Europäisches Patentamt

(19) European Patent Office

Office européen des brevets

(11) **EP 0 834 881 A1**

(12) **EUROPEAN PATENT APPLICATION**

(43) Date of publication:
08.04.1998 Bulletin 1998/15

(51) Int. Cl.$^6$: **G11C 7/00**, G11C 8/00

(21) Application number: 96830501.1

(22) Date of filing: 01.10.1996

(84) Designated Contracting States:
DE FR GB IT
Designated Extension States:
AL LT LV SI

(71) Applicant:
SGS-THOMSON MICROELECTRONICS s.r.l.
20041 Agrate Brianza (Milano) (IT)

(72) Inventors:
• Varambally, Rajamohan
Udupi 576102, DK Karnataka (IN)

• Bauer, Jean-Luc
68280 Sundhoffen (FR)
• Hardi, Anand
Narainpur Dharwad 580008 (IN)

(74) Representative:
de Beaumont, Michel
1bis, rue Champollion
38000 Grenoble (FR)

(54) **A multi-block memory**

(57) The invention relates to a memory including a matrix of memory cells (10) arranged in rows and columns, wherein each memory cell in a column is coupled to at least one global bit line (GBL) common to the column for providing the state of the memory cell, and each column is divided in subcolumns having, each, several memory cells connected to a local bit line (LBL) which is in turn connected to the global bit line through a pass gate (30).

Fig 3

## Description

The present invention relates to a memory whose power consumption is reduced by splitting the matrix of memory cells into several blocks which are accessed individually.

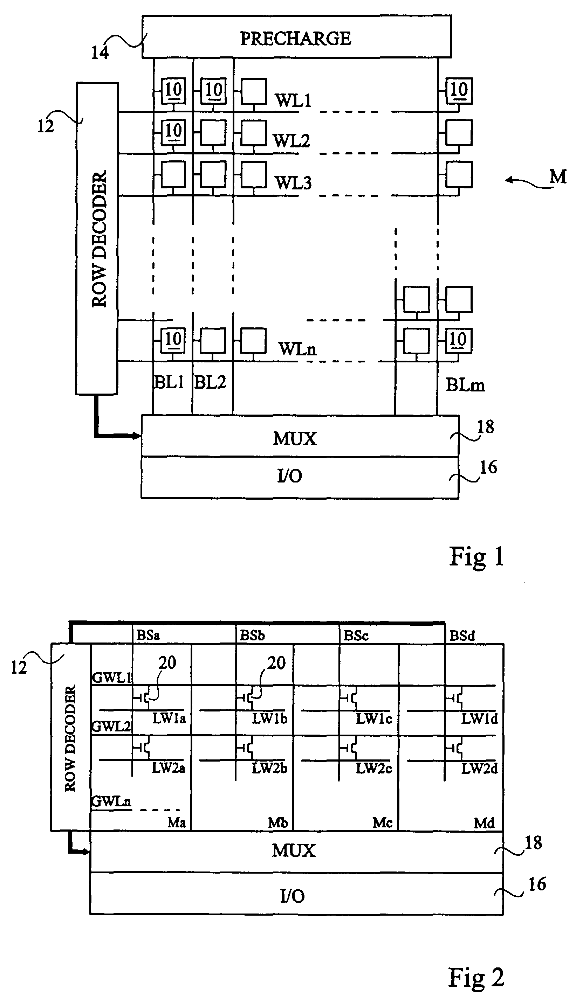

Figure 1 shows a conventional memory structure with a single matrix M of memory cells 10. Each row i (i=1, 2... n) of memory cells is selected for access by a row decoder 12 through a respective word line WL$_i$ (WL$_1$, WL$_2$... WL$_n$). The memory cells 10 of each column j (j=1, 2... m) are connected to a common bit line BL$_j$ (BL$_1$, BL$_2$... BL$_m$). There is usually a pair of complementary bit lines for each column, but only one bit line is shown for sake of simplicity. Bit lines BL are coupled to precharge circuitry 14 and to input/output circuits 16.

Each row of memory cells generally contains several words, so that the shape of the memory is more compact and close to a square. Multiplexers 18 are provided to select the appropriate bit lines BL for the input/output circuits 16.

In operation, all the bit lines BL are precharged to a high value between two access cycles of the memory. During an access cycle, for example a read cycle, one row is selected and the cells of the selected row will discharge the bit lines BL or leave them precharged, depending on the states stored in the cells. The input/output circuitry 16 detects the levels on the bit lines BL and provides the corresponding word. During a write cycle, the bit lines are discharged down to a level causing the change of the corresponding selected cells.

With a pair of complementary bit lines per column, one bit line of each pair is discharged at every access cycle.

This precharging and discharging of the bit lines is the most significant contribution to the power consumption of the memory, because there is usually a large number of columns. Moreover, the capacitance of the bit lines increases with the number of rows, increasing the power consumption and reducing the operation speed.

In the memory structure of figure 1, all the bit lines are likely to be discharged, even those which are not selected by the multiplexers 18, causing useless power consumption.

In order to reduce the power consumption, it is usual to split up the rows in several subrows which are individually selectable. Then, only the subrow containing the word to be accessed is selected, whereby only the bit lines associated to the selected subrow are discharged.

With this technique, the number of word selection lines is multiplied by the number of subrows in a row, whereby the area of the memory is likely to increase.

Figure 2 illustrates a conventional area efficient solution used for reducing the number of columns selected at one time. The matrix of memory cells is divided into several vertical blocks, for example four blocks Ma to Md.

The row decoder 12 drives one global word line GWL$_i$ for each row i. The four subrows belonging to row i are separately selectable through respective local word lines LW$_{ia}$ to LW$_{id}$. Each local word line LW$_{ik}$ (k= a, b, c, or d) is coupled to the corresponding global word line GWL$_i$ through a switch transistor 20 and all the switch transistors 20 of block Mk are controlled by the row decoder 12 through a common block selection line BS$_k$.

An object of the invention is to provide a memory structure which may be used in combination with any conventional memory structure, such as that of figures 1 and 2, in order to further reduce the power consumption and increase the speed of operation, and this without significantly increasing the silicon area.

The conventional techniques for reducing power consumption, such as that used in the structure of figure 2, are based on reducing the number of bit lines which are discharged at one time.

In contrast, the invention is based on the reduction of the capacitance of the bit lines. The capacitance of each bit line depends on its geometry, but also greatly on the number of elements connected to the bit line, especially the pass transistors which couple the memory cells of a column to the bit line.

The invention achieves the above object by reducing the number of elements, such as pass transistors, connected to each bit line, without reducing the number of cells in a column. This is achieved, more specifically, by providing a memory including a matrix of memory cells arranged in rows and columns, wherein each memory cell in a column is coupled to at least one global bit line common to the column for providing the state of the memory cell, and each column is divided in subcolumns having, each, several memory cells connected to a local bit line which is in turn connected to the global bit line through a pass gate.

In order to increase the speed of operation, each subcolumn has a local sense amplifier connected to the corresponding local bit line for accelerating the discharge of the bit lines.

According to an embodiment of the invention, the memory comprises control means for successively selecting a memory cell, enabling the corresponding local sense amplifier, and enabling the corresponding pass gate.

According to an embodiment of the invention, said control means are operative to deselect said memory cell upon the enabling of the local sense amplifier.

According to an embodiment of the invention, each memory cell is coupled to two complementary local bit lines, and each local sense amplifier comprises two transistors respectively coupling the two corresponding complementary local bit lines to a discharge voltage through a common enable transistor, each of the transistors connected to one of the complementary local bit lines being controlled by the other complementary local bit line.

According to an embodiment of the invention, the memory comprises means for precharging the global bit lines to a predetermined level during a precharge phase between two consecutive selections of memory cells, and said pass gates are connected such that they are enabled during the precharge phases.

The foregoing and other objects, features, aspects and advantages of the invention will become apparent from the following detailed description of embodiments, given by way of illustration and not of limitation with reference to the accompanying drawings, among which:

figures 1 and 2, previously described, show conventional memory structures;
figure 3 shows an embodiment of a mamory structure according to the invention;
figure 4 shows an advantageous embodiment of a memory structure according to the invention, having an increased operating speed; and
figure 5 shows an example of a local sense amplifier used in the embodiment of figure 4.

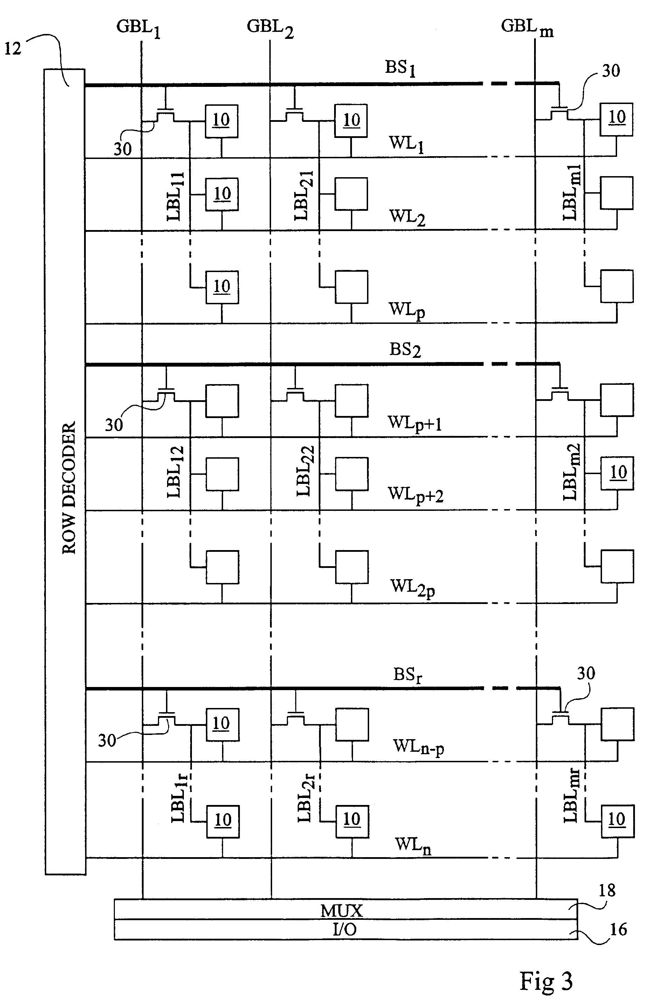

In figure 3, according to the invention, each column of memory cells 10 is divided into r subcolumns of p memory cells. Each memory cell of a subcolumn is connected to a local bit line $LBL_{ij}$ ($i = 1$ to $m$, $j = 1$ to $r$). Each local bit line $LBL_{ij}$ is coupled to a global bit line $GBL_i$ through a pass gate or transistor 30. Each global bit line GBL, like the bit lines BL in the conventional memory structures, is common to a respective column and connected to precharge circuitry (not shown), and to multiplexing and input/output circuits 18, 16.

In the shown embodiment, each row of memory cells 10 is selected conventionally by row decoder 12 through a respective word line WL, like in the single matrix structure of figure 1. The invention also applies to a vertical multi-block structure such as that of figure 2, where each subrow would be selected through a respective local word line LW.

Each row of subcolumns defines a horizontal block which is selectable through a block selection line BS driving all the pass transistors 30 in the row of subcolumns. Thus, according to the invention, the rows are grouped into several horizontal blocks, whereas in the conventional multi-block structure of figure 2, the columns are grouped into several vertical blocks.

During an access cycle, for example a read cycle, a row is conventionally selected by asserting the corresponding word line WL. The selected cells then discharged the corresponding local bit lines LBL. Upon the selection of the row, or shortly after, the corresponding block selection line BS is asserted by the row decoder, whereby the corresponding pass transistors 30 are turned on. The selected cells then discharge the global bit lines GBL through the pass transistors 30 and the local bit lines LBL. The access cycle then proceeds conventionally, like in the structures of figures 1 and 2.

In a memory structure according to the invention, the global bit lines GBL will have substantially the same geometry as the bit lines of a conventional structure. However, the number of pass transistors effectively connected to each global bit line is dramatically reduced, which correspondingly reduces the capacitance of the bit lines. Indeed, in the structure according to the invention, there are only r+p pass transistors connected to each global bit line whereas, in a conventional structure, there are $rp = n$ pass transistors connected to each bit line. Of course, the capacitance of each global bit line GBL is increased by the capacitance of one local bit line LBL, but this increase is largely compensated by the capacitance reduction caused by the fewer pass transistors connected to the global bit line.

The reduced capacitance of the bit lines not only reduces the power consumption correspondingly, but also increases the speed of operation because the bit lines will charge and discharge faster. This is advantageous as compared to the multi-block structure of figure 2 where the power consumption is reduced but where the speed is not increased because the capacitance of the bit lines is not reduced.

Of course, between two consecutive memory accesses, the local bit lines LBL should be precharged like the global bit lines GBL. To achieve this, a precharge transistor could be connected to each local bit line LBL like, conventionally, to each global bit line GBL. A preferred more area efficient solution is to connect the block selection lines BS so that they are all asserted during the precharge phases, whereby all the local bit lines LBL are precharged through the pass transistors 30 while the global bit lines GBL are precharged.

The power consumption is also reduced during the precharge phases, because only one local bit line LBL in each column will have been discharged during a previous access cycle.

By using recent integrated circuit technologies with three metal layers or more, the structure according to the invention of figure 3 hardly occupies more silicon area than the conventional structure of figure 1. First, the area occupied by the additional logic for controlling the block selection lines BS and by the pass transistors 30 is negligible. Second, with three metal layers or more, the additional local bit lines LBL and the block selection lines BS can be created in metal layers distinct from those of the global bit lines GBL and the word lines WL, without occupying more area.

The memory structure of figure 3 may be combined more generally with any existing structure, such as the multi-block structure of figure 2, without occupying significantly more area than the existing structure.

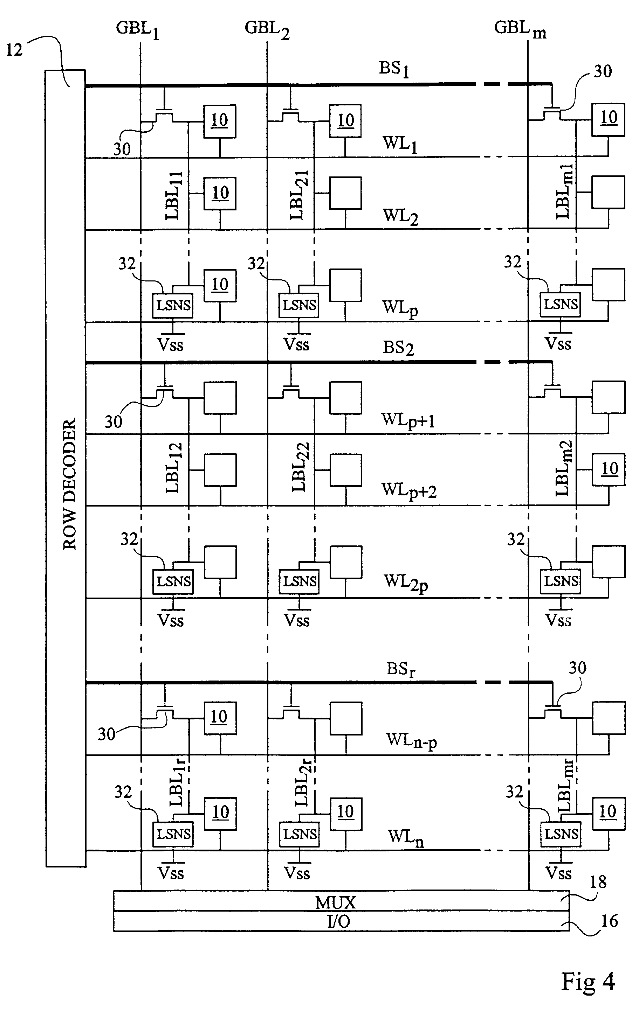

Figure 4 shows the memory structure of figure 3 incorporating, according to an embodiment of the invention, circuitry for increasing the speed of operation.

As compared to the structure of figure 3, that of figure 4 includes, for each local bit line LBL, a local sense amplifier 32 connected between the local bit line and a voltage Vss corresponding to the discharged state of the bit lines.

The purpose of each local sense amplifier 32 is to provide a higher discharge speed than a memory cell 10. Since the number of local sense amplifiers 32 is significantly lower than the number of memory cells 10, the transistors of the local sense amplifiers 32 can be larger than those of the memory cells, and can thus pass more discharge current.

During an access cycle, for example a reed cycle, the local sense amplifiers 32 are enabled shortly after a row selection. The local sense amplifiers will then discharge the local bit lines LBL together with the selected memory cells 10, whereby the local bit lines discharge faster, especially if the transistors of the local sense amplifiers are large.

Shortly after enabling the local sense amplifiers 32, the block selection line BS corresponding to the selected row is asserted. The global bit lines GBL are then connected to the corresponding local bit lines LBL and thus discharged through the local sense amplifiers 32 at a much faster rate than when they are discharged by the selected memory cells alone.

Each local sense amplifier 32 may be comprised, like a conventional sense amplifier, of two back-to-back inverters associated with a pull-down enable transistor.

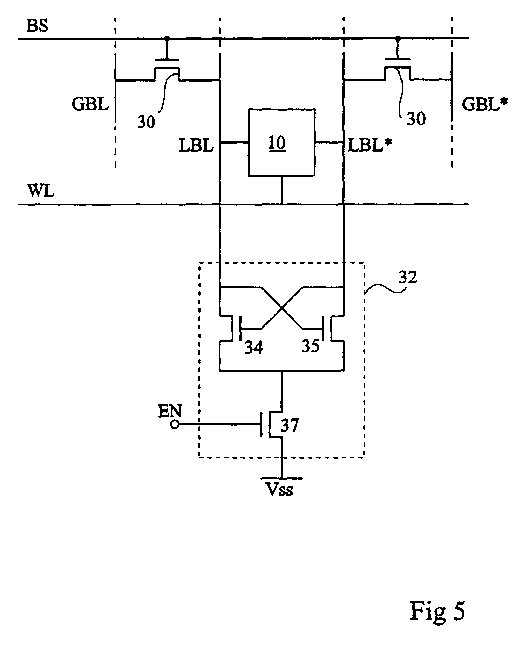

Figure 5 shows an advantageous embodiment of a local sense amplifier 32 which may be used in the situation where each memory cell has a pair of complementary outputs. As shown, these two outputs are then connected to two complementary local bit lines LBL and LBL* which are in turn respectively connected to two complementary global bit lines GBL and GBL* through two pass transistors 30. The two pass transistors 30 are controlled by the same block selection line BS.

The local sense amplifier 32 comprises two transistors 34 and 35 respectively coupling the local bit lines LBL and LBL* to a common enable transistor 37. Transistor 37 is controlled by an enable signal EN for connecting transistors 34 and 35 to voltage Vss, corresponding to the discharged state of the bit lines.

Before a row selection, all the bit lines are at a high precharged state, whereby transistors 34 and 35 are on. However, transistor 37 is off (the local sense amplifier is disabled).

When a row is selected by a word line WL, the local sense amplifier 32 is not immediately enabled. The selected memory cell 10 starts discharging one of the complementary local bit lines, for example LBL, depending on the state stored in the memory cell.

When a sufficient voltage differential is reached between lines LBL and LBL*, for example 100 mV, the local sense amplifier 32 is enabled by turning on transistor 37. Only the local sense amplifiers 32 of the subcolumns where the row is selected are enabled. Since, in the above example, line LBL* is at the high precharged state and line LBL is discharging, transistor 34 is fully on, whereas transistor 35 is starting to turn off. As a consequence, line LBL discharges through transistor 34 while transistor 35 draws a rapidly decreasing amount of current from line LBL*.

When the local sense amplifier 32 has been enabled, preferably a small delay thereafter (such as obtained by two inverters), the corresponding block selection line BS is asserted. Then, in the example, the global bit line GBL discharges rapidly through transistors 30, 34 and 37, and also through the selected memory cell 10 if the word line WL remains asserted.

The local sense amplifier 32 has only three N-channel transistors whereas a memory cell 10 has six transistors, including two P-channel transistors. Therefore, the local sense amplifier 32 may occupy the same area as a memory cell but include more than double-size transistors which will have lower on-resistances than the transistors of a memory cell, and thus discharge the bit lines faster.

If the size of the local sense amplifier 32 is chosen substantially equal to the size of a memory cell, the area of the memory structure will increase by a factor 1/p, where p is the number of cells in a subcolumn. This area increases is acceptable when an increased operating speed is necessary, especially when the number p of cells in a subcolumn is high.

The local sense amplifier 32 of figure 5 draws insignificant power, because it acts on local bit lines which are short and thus have a low capacitance as compared to the global bit lines.

To cancel any power consumption in the local sense amplifier 32, the word line WL may be disabled as soon as the local sense amplifier is enabled. Then, both the local bit lines LBL and LBL* will be discharged by the local sense amplifier, but only one will be discharged completely (LBL in the above example) while the other, LBL*, will only be discharged slightly. As a consequence, transistor 34 remains on and pulls down local bit line LBL while transistor 35 is off causing local bit line LBL* to float at a level slightly below the precharged state. When the pass transistors 30 are turned on, the slight discharged state of local bit line LBL* hardly affects the precharged state of global bit line GBL*, since the capacitance of line LBL* is much lower than that of line GBL*. In contrast, lines LBL and GBL are still rapidly discharged through transistors 34 and 37 of the local sense amplifier 32.

The delay between a row selection and the subsequent enabling of the corresponding local sense amplifiers 32 is short, because it depends on the discharge speed of the local bit lines which have a low capacitance as compared to the global bit lines. The delay for enabling the local sense amplifiers 32 may be obtained simply by a small chain of inverters. The delay between the enabling of the local sense amplifiers and the subsequent assertion of the corresponding block selection line BS is also short and obtainable by a small chain of inverters connected between line BS and a line for enabling the local sense amplifiers.

The control (especially row decoder 12) of a memory structure according to the invention is simple and the necessary circuitry can easily be realized by those skilled in the art on the basis of the functional explanations provided in the above description.

## Claims

1. A memory including a matrix of memory cells (10) arranged in rows and columns, wherein each memory cell in a column is coupled to at least one global bit line (GBL) common to the column for providing the state of the memory cell, characterized in that each column is divided in subcolumns having, each, several memory cells connected to a local bit line (LBL) which is in turn connected to the global bit line through a pass gate (30).

2. The memory according to claim 1, characterized in that each subcolumn has a local sense amplifier (32) connected to the corresponding local bit line for accelerating the discharge of the bit lines (LBL, GBL).

3. The memory according to claim 2, characterized in that it comprises control means (12) for successively selecting a memory cell (10), enabling the corresponding local sense amplifier (32), and enabling the corresponding pass gate (30).

4. The memory according to claim 3, characterized in that said control means are operative to deselect said memory cell upon the enabling of the local sense amplifier.

5. The memory according to claim 2, characterized in that each memory cell (10) is coupled to two complementary local bit lines (LBL, LBL*), and in that each local sense amplifier (32) comprises two transistors (34, 35) respectively coupling the two corresponding complementary local bit lines to a discharge voltage (Vss) through a common enable transistor (37), each of the transistors connected to one of the complementary local bit lines being controlled by the other complementary local bit line.

6. The memory according to any of claims 1 to 5, comprising means (14) for precharging the global bit lines (GBL) to a predetermined level during a precharge phase between two consecutive selections of memory cells, characterized in that said pass gates (30) are connected such that they are enabled during the precharge phases.

Fig 1

Fig 2

Fig 3

Fig 4

Fig 5

## EUROPEAN SEARCH REPORT

**European Patent Office**

Application Number

EP 96 83 0501

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US 4 819 207 A (SAKUI KOJI ET AL) 4 April 1989 | 1-3,5 | G11C7/00 G11C8/00 |
| A | * the whole document * | 4,6 | |
| X | EP 0 593 152 A (SUN MICROSYSTEMS INC) 20 April 1994 | 1-3,5 | |
| A | * column 2, line 45 - column 10, line 19; figures 2-5 * | 4,6 | |
| X | US 5 245 570 A (FAZIO ALBERT ET AL) 14 September 1993 | 1 | |
| Y | * column 4, line 49 - column 11, line 54; figures 2,3 * | 2,3,6 | |
| Y | US 5 353 255 A (KOMURO TOSHIO) 4 October 1994 * column 1, line 53 - column 2, line 17 * | 2,3,6 | |
| A | EP 0 635 839 A (TOKYO SHIBAURA ELECTRIC CO) 25 January 1995 * abstract * | 1-6 | |

TECHNICAL FIELDS SEARCHED (Int.Cl.6)

G11C

The present search report has been drawn up for all claims

| Place of search | Date of completion of the search | Examiner |
|---|---|---|
| THE HAGUE | 17 March 1997 | Schenkels, P |